# EUROPEAN PATENT APPLICATION

(11) **EP 4 521 459 A1**
(43) Date of publication of application: **12.03.2025**
(21) Application number: 24812352.3
(22) Date of filing: 09.05.2024
(51) Int. Cl.: H01L 23/498, H01L 23/12

(54) **PACKAGING STRUCTURE AND SEMICONDUCTOR STRUCTURE**

(30) Priority: 29.05.2023 CN 202310625033
(71) Applicant: CXMT Corporation, Hefei City, Anhui Province 230601 (CN)
(72) Inventor: SHI, Hengrong, Hefei, Anhui 230601 (CN); AHN, Eun Chul, Hefei, Anhui 230601 (CN); CHENG, Jingwei, Hefei, Anhui 230601 (CN)
(74) Representative: Gulde & Partner
(86) International application number: PCT/CN2024/091816
(87) International publication number: WO 2024/244930

(57) **Abstract**

A package structure and a semiconductor structure are provided. A ball grid array is disposed on a surface of a package substrate in the package structure, and the ball grid array includes multiple data ball grids. In a second direction, a maximum of two data ball grids are allowed to be consecutively arranged. The second direction is a row extension direction of the ball grid array. The package structure has a small size.

## Description

This application claims priority to Chinese Patent Application No. 202310625033.4, filed with the China National Intellectual Property Administration on May 29, 2023 and entitled "PACKAGE STRUCTURE AND SEMICONDUCTOR STRUCTURE", which is incorporated herein by reference in its entirety.

### TECHNICAL FIELD

Embodiments of the present disclosure relate to the field of semiconductor technologies, and in particular, to a package structure and a semiconductor structure.

### BACKGROUND

Currently, a semiconductor chip (e.g., a dynamic random access memory (DRAM)) relates to various types of input/output signals (e.g., a command address signal, a data signal, and a data strobe signal) that need to be packaged through a ball grid. However, because quantities, level change rules, and functions of different types of signals are different, a position arrangement manner of corresponding ball grids of different types of signals affects performance of the chip.

### SUMMARY

According to a first aspect of the embodiments of the present disclosure, a package structure is provided and includes:
a package substrate, where a ball grid array is disposed on a surface of the package substrate, the ball grid array includes multiple data ball grids, and each of the data ball grids is configured to transmit a data signal; and in a second direction, a maximum of two of the data ball grids are allowed to be consecutively arranged, and the second direction is a row extension direction of the ball grid array.

In some embodiments, a first part of the data ball grids are located in an edge row and a non-edge column of the ball grid array, and any one of the data ball grids in the first part is not linearly adj acent to another one of the data ball grids; a second part of the data ball grids are located in a non-edge row and non-edge column of the ball grid array, and every two of the data ball grids in the second part are adjacent to each other in the second direction; and the data ball grids are distributed in only one of any two adjacent rows of the ball grid array.

In some embodiments, the ball grid array further includes multiple command address ball grids, where each of the command address ball grids is configured to transmit a command/address signal; a first part of the command address ball grids are located in an edge row and a non-edge column of the ball grid array, and any one of the command address ball grids in the first part is not linearly adj acent to another one of the command address ball grids; and a second part of the command address ball grids are located in a non-edge row and non-edge column of the ball grid array, a maximum of two of the command address ball grids in the second part are allowed to be consecutively arranged in the second direction, a maximum of three of the command address ball grids in the second part are allowed to be consecutively arranged in a first direction, and the first direction is a column extension direction of the ball grid array.

In some embodiments, the ball grid array has N rows in total, the first part of the data ball grids are located in the first row, the second part of the data ball grids are all located in the second row to the A^{th} row, the second part of the command address ball grids are all located in the B^{th} row to the (N-1)^{th} row, and the first part of the command address ball grids are located in the N^{th} row, A, B, and N are all positive integers, A is less than B, and B is less than N-1.

In some embodiments, the data ball grids located in the first row to the (C-1)^{th} row are configured to transmit an upper data signal, and the data ball grids located in the (C+1)^{th} row to the A^{th} row are configured to transmit a lower data signal; or the data ball grids located in the first row to the (C-1)^{th} row are configured to transmit a lower data signal, and the data ball grids located in the (C+1)^{th} row to the A^{th} row are configured to transmit an upper data signal; and each ball grid located in the C^{th} row is a ground ball grid or a power ball grid, the ground ball grid is configured to transmit a ground signal, the power ball grid is configured to transmit a power signal, and C=(A+1)/2.

In some embodiments, the ball grid array is divided into a first array, a central array, and a second array, the first array, the central array, and the second array are sequentially arranged in the second direction, the quantity of ball grids in the first array is the same as the quantity of ball grids in the second array, and all ball grids in the central array are removed.

The data ball grids located in the first array are symmetrical to the data ball grids located in the second array with respect to the central array, and the command address ball grids located in the first array are symmetrical to the command address ball grids located in the second array with respect to the central array.

In some embodiments, the ball grid array further includes multiple data strobe ball grids, where each of the data strobe ball grids is configured to transmit a data strobe signal; and in the second direction, each of the data strobe ball grids is adjacent to the central array, the data strobe ball grids are allowed to be adjacent to the data ball grids in the first direction, and the data strobe ball grids are allowed to be adjacent to the data ball grids in the second direction. The ball grid array further includes multiple mask control ball grids, and each of the mask control ball grids is configured to transmit a mask inversion control signal or a terminal data strobe signal; and the mask control ball grids are symmetrical to the data strobe ball grids with respect to the central array.

In some embodiments, the ball grid array further includes a local data strobe ball grid, a local data ball grid, and a calibration indication ball grid; the local data strobe ball grid is located in an edge column, and the local data strobe ball grid is adjacent to the data ball grid in the second direction; and the local data strobe ball grid is symmetrical to the local data ball grid with respect to the central array. The calibration indication ball grid is adjacent to the local data strobe ball grid in the first direction; and the local data ball grid is configured to transmit a local data signal, the local data strobe ball grid is configured to transmit a local data strobe signal, and the calibration indication ball grid is configured to transmit an impedance calibration signal.

In some embodiments, the ball grid array further includes multiple chip select ball grids adjacent to each other in the first direction, and each of the chip select ball grids is configured to transmit a chip select signal; one part of the chip select ball grids are adjacent to one of the data ball grids in the first direction; and the other part of the chip select ball grids are adjacent to one of the command address ball grids in the second direction, and are adjacent to another one of the command address ball grids in the first direction.

In some embodiments, the ball grid array further includes multiple clock ball grids adj acent to each other in the first direction, and each of the clock ball grids is configured to transmit a clock signal; one part of the clock ball grids are not linearly adjacent to any one of the command address ball grids, and are not linearly adjacent to any one of the data ball grids; and the other part of the clock ball grids are adj acent to one of the command address ball grids in the second direction, and are adjacent to another one of the command address ball grids in the first direction.

In some embodiments, the multiple chip select ball grids are located in the first array and adjacent to an edge column of the ball grid array; the multiple clock ball grids are located in the second array and adjacent to the central array; and one of the chip select ball grids and one of the clock ball grids are located in the same row.

In some embodiments, the ball grid array further includes a check error indication ball grid and a mirror mode ball grid, and both the check error indication ball grid and the mirror mode ball grid are located in an edge column of the ball grid array; the mirror mode ball grid is adjacent to one of the chip select ball grids in the second direction; the error indication ball grid is adjacent to another one of the chip select ball grids in the second direction; and the mirror mode ball grid is configured to transmit at least a mirror mode enable signal, and the error indication ball grid is configured to transmit a check error indication signal.

In some embodiments, the ball grid array further includes multiple reserved ball grids, one test mode ball grid, and two protocol ball grids, the test mode ball grid is configured to transmit a test mode enable signal, and each of the protocol ball grids is configured to transmit a protocol control signal; the multiple reserved ball grids are symmetrical to the multiple chip select ball grids with respect to the central array; and a second one of the protocol ball grids is symmetrical to the mirror mode ball grid with respect to the central array, the test mode ball grid is symmetrical to the error indication ball grid with respect to the central array, and a first one of the protocol ball grids, the second one of the protocol ball grids, and the test mode ball grid are consecutively arranged in the first direction.

In some embodiments, the ball grid array further includes a termination ball grid and a reset ball grid, and the termination ball grid and the reset ball grid are located in an edge column of the ball grid array; and the termination ball grid is symmetrical to the reset ball grid with respect to the central array. Ball grids linearly adjacent to the termination ball grid are all ground ball grids and/or power ball grids, the termination ball grid is located in the same row as at least one of the command address ball grids, and the reset ball grid is located in the same row as at least one of the command address ball grids; and the termination ball grid is configured to transmit an on-chip termination command, and the reset ball grid is configured to transmit a reset signal.

According to a second aspect, an embodiment of the present disclosure provides a semiconductor structure, including the package structure according to the first aspect and a chip, where a data bit width of the chip is 4 bits, 8 bits, or 16 bits.

The embodiments of the present disclosure provide a package structure and a semiconductor structure, which can be compatible with chips of different specifications, and have strong adaptability and a small overall area.

### BRIEF DESCRIPTION OF DRAWINGS

FIG. 1 is a schematic diagram of a package structure according to an embodiment of the present disclosure;
FIG. 2 is a schematic diagram of a ball grid array according to an embodiment of the present disclosure;
FIG. 3 is a schematic diagram 1 of a detailed structure of a ball grid array according to an embodiment of the present disclosure;
FIG. 4 is a schematic diagram of another ball grid array according to an embodiment of the present disclosure;
FIG. 5 is a schematic diagram 2 of a detailed structure of a ball grid array according to an embodiment of the present disclosure; and
FIG. 6 is a schematic structural diagram of a semiconductor structure according to an embodiment of the present disclosure.

### DESCRIPTION OF EMBODIMENTS

The technical solutions of the present disclosure are further described below in detail with reference to the accompanying drawings and the embodiments. Although example implementations of the present disclosure are shown in the accompanying drawings, it should be understood that the present disclosure may be implemented in various forms without being limited by the implementations described herein. Instead, these implementations are provided to develop a more thorough understanding of the present disclosure and to fully convey the scope of the present disclosure to a person skilled in the art.

In the following paragraphs, the present disclosure is described more specifically by way of example with reference to the accompanying drawings. The advantages and features of the present disclosure will be clearer from the following description and claims. It should be noted that the accompanying drawings are presented in a highly simplified form and are not drawn to exact scale, and are merely intended to conveniently and clearly assist in describing the embodiments of the present disclosure.

It may be understood that meanings of "on", "over", and "above" in the present disclosure should be understood in the broadest sense, so that "on" means that it is "on" something with no intermediate feature or layer (that is, directly on something), and further includes the meaning that it is "on" something with an intermediate feature or layer.

In the embodiments of the present disclosure, the terms "first", "second", "third", and the like are intended to distinguish between similar objects but do not necessarily indicate a specific order or sequence.

In the embodiments of the present disclosure, the term "layer" refers to a material part including a region having a thickness. The layer may extend over the whole of a lower or upper structure, or may have a range smaller than the range of the lower or upper structure. In addition, the layer may be a region of a homogeneous or heterogeneous continuous structure whose thickness is less than the thickness of a continuous structure. For example, the layer may be located between the top surface and the bottom surface of the continuous structure, or the layer may be located between any horizontal surface pair at the top surface and the bottom surface of the continuous structure. The layer may extend horizontally, vertically, and/or along an inclined surface. Multiple sublayers may be included in the layer.

It should be noted that the technical solutions described in the embodiments of the present disclosure may be arbitrarily combined when there is no conflict.
Static random access memory (SRAM);
synchronous dynamic random access memory (SDRAM);
double data rate SDRAM (DDR);
fifth generation DDR (DDR5);
sixth generation DDR (DDR6);
two-wire bidirectional serial bus protocol (I3C); and
printed circuit board (PCB).

Before the embodiments of the present disclosure are described, three directions that may be configured to describe a three-dimensional structure of a plane in the following embodiments are first defined. In an example of a Cartesian coordinate system, the three directions may include an X-axis direction, a Y-axis direction, and a Z-axis direction (which is not included in the embodiments of the present disclosure). A package structure may include a top surface located on the front and a bottom surface located on the back opposite to the front. When flatness of the top surface and the bottom surface is ignored, a direction intersecting with (e.g., perpendicular to) the top surface and the bottom surface of the package structure is defined as a third direction. In a direction of the top surface and the bottom surface (that is, a plane on which the package structure is located) of the package structure, two directions intersecting with each other are defined. For example, a column extension direction of a ball grid array may be defined as a first direction, a row extension direction of the ball grid array may be defined as a second direction, and a plane direction of the package structure may be determined based on the first direction and the second direction. In the embodiments of the present disclosure, the first direction and the second direction may be perpendicular to each other. In another embodiment, the first direction and the second direction may not be perpendicular to each other.

In addition, the term "linearly adjacent" employed in combination with the ball grid array in this specification represents and includes ball grids directly above, directly below, directly on the left, and directly on the right of a given ball grid when the ball grid array is parallel to the plane of the drawing; the term "diagonal arrangement" employed in combination with the ball grid array in this specification represents and includes ball grids on the upper right, the lower right, the upper left, and the lower left of a given ball grid when the ball grid array is parallel to the plane of the drawing; and the term "around the ball grid" employed in combination with the ball grid array in this specification represents and includes ball grids directly above, directly below, directly on the left, directly on the right, on the upper right, on the lower right, on the upper left, and on the lower left of a given ball grid when the ball grid array is parallel to the plane of the drawing. The term "a ball grid A is adjacent to a ball grid B in a first direction" employed in combination with the ball grid array in this specification includes only that when the ball grid array is parallel to the plane of the drawing, the ball grid A is adjacent to the ball grid B and the ball grid A is directly above or directly below the ball grid B. The term "a ball grid A is adjacent to a ball grid B in a second direction" employed in combination with the ball grid array in this specification includes only that when the ball grid array is parallel to the plane of the drawing, the ball grid A is adjacent to the ball grid B and the ball grid A is directly on the left or directly on the right of the ball grid B.

In particular, the illustrations presented in the present disclosure are not meant to be actual views of any specific microelectronic device package, ball grid array, or components thereof, but are only idealized representations for describing illustrative embodiments. Therefore, the illustrations are not necessarily drawn to scale.

DDR6 chips with a 4-bit data bit width (X4), an 8-bit data bit width (X8), and a 16-bit data bit width (X16) are included in subsequent descriptions of the embodiments of the present disclosure. Therefore, Table 1 is provided to describe related signals and the quantities of signals to be employed during packaging of the foregoing chips.

**Table 1**

| | | DDR6 X16 | DDR6 X8 | DDR6 X4 |
|---|---|---|---|---|
| Lower data related | Lower data signal dql[7:0] | 8 | 8 | 4 |
| | Lower data strobe signal dqsl_t/dqsl_c | 2 | 2 | 2 |
| | Terminal data strobe signal tdqs_t (lower mask inversion control signal dml) | 1 | 1 | 1 |
| Upper data related | Upper data signal dqu[7:0] | 8 | 0 | 0 |
| | Upper data strobe signal dqsu_t/dqsu_c | 2 | 0 | 0 |
| | Terminal data strobe signal tdqs_c (upper mask inversion control signal dmu) | 1 | 1 | 1 |
| Locally related | Local data signal lbdq/Local data strobe signal lbdqs | 2 | 2 | 2 |
| Command address related | Command address signal ca[13:0] | 14 | 14 | 14 |
| | On-chip termination signal ca_odt | 1 | 1 | 1 |
| | Clock signal ck_t/ck_c | 2 | 2 | 2 |
| Power support related | Power signal vddq | 15 | 15 | 15 |
| | Power signal vdd | 15 | 15 | 15 |
| | Ground signal vss | 20 | 20 | 20 |
| | Power signal vpp | 2 | 2 | 2 |
| Others | Test mode enable signal ten | 1 | 1 | 1 |
| | Chip select signal cs_n[1:0] | 2 | 2 | 2 |
| | I3C protocol-related signal (msda and msdl) | 2 | 2 | 2 |
| | Mirror mode enable signal mir | 1 | 1 | 1 |
| | Impedance calibration signal zq | 1 | 1 | 1 |
| | Check error indication signal alert_n | 1 | 1 | 1 |
| | Reset signal reset | 1 | 1 | 1 |
| | Reserved signal rfu | 2 | 2 | 2 |
| Total | | 104 | - | - |

In particular, the X8 chip requires the terminal data strobe signals tdqs_c and tdqs_t, and the X4 chip and the X16 chip do not require the terminal data strobe signals tdqs_c and tdqs_t, but require the mask inversion control signals dmu_n and dml_n. In particular, for the same design specification, the terminal data strobe signal may share the same ball grid with the mask inversion control signal, that is, tdqs_c and dmu_n share one ball grid, and tdqs_t and dml_n share one ball grid.

The following describes the embodiments of the present disclosure in detail with reference to the accompanying drawings.

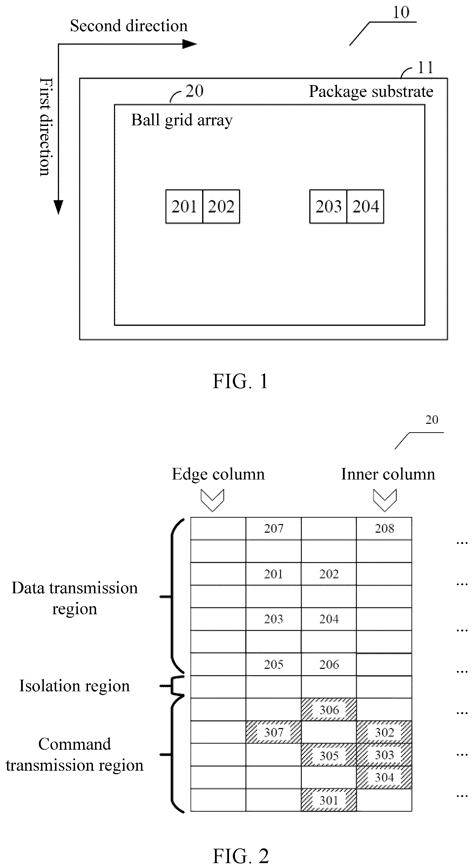

In an embodiment of the present disclosure, FIG. 1 is a schematic diagram of a package structure 10 according to an embodiment of the present disclosure. As shown in FIG. 1, the package structure 10 includes a package substrate 11, where a ball grid array 20 is disposed on a surface of the package substrate 11.

It should be noted that, the package structure 10 provided in this embodiment of the present disclosure is applicable to at least a DDR5 or a DDR6, and may simultaneously support DDR5 and DDR6 chips whose data bit widths are 4 bits, 8 bits, and 16 bits. Specifically, the DDR chip includes a device substrate, and the device substrate includes a semiconductor material and a bond pad coupled to an active surface of the device substrate. The package substrate is fastened to the device substrate, the package substrate 11 is configured to route signals to/from the bond pad, and the ball grid array 20 is supported on and electrically connected to the package substrate 11. In particular, the distribution position of the ball grid array 20 on the package substrate 11 is merely an example and constitutes no limitation. Actually, a surface of the package substrate 11 is not necessarily a completely regular rectangle, and the ball grid array 20 may be distributed in any region on the surface of the package substrate 11.

In the following description, a first direction is a column extension direction of the ball grid array 20, and a second direction is a row extension direction of the ball grid array 20.

As shown in FIG. 1, the ball grid array 20 includes multiple data ball grids (only a part of the data ball grids, that is, 201 to 204, are shown in FIG. 1), and each of the data ball grids is configured to transmit a data signal (e.g., dqu[7:0] or dql[7:0] in Table 1). In the second direction, a maximum of two data ball grids are allowed to be consecutively arranged.

In this way, in this embodiment of the present disclosure, two data ball grids are allowed to be arranged adjacent to each other, and the quantity of rows occupied by the data ball grid array can be decreased to reduce a package size, and the length of a line connecting a data pin to an input/output (I/O) terminal of the chip is further reduced, which is beneficial to high-rate storage products. In addition, if three or more data ball grids are arranged adjacent to each other, a relatively strong inter-signal crosstalk is generated, causing signal distortion.

In some embodiments, the data ball grids are distributed in only one of any two adjacent rows of the ball grid array 20, that is, no other data ball grids are distributed in a row preceding or following a row in which each data ball grid is located. For example, FIG. 2 is a schematic diagram of another ball grid array 20 according to an embodiment of the present disclosure. As shown in FIG. 2, the data ball grids are distributed in the first row, the third row, the fifth row, and the seventh row. In this way, a maximum of one other data ball grid exists around (directly above, directly below, directly on the left of, directly on the right of, on the upper left of, on the lower left of, on the upper right of, and on the lower left of) each data ball grid, thereby alleviating signal distortion caused by magnetic field superposition.

In some embodiments, referring to FIG. 2, the data ball grids may be classified into two parts based on features of distribution positions:
(1) A first part of the data ball grids (207 and 208 in FIG. 2) are located in an edge row and a non-edge column of the ball grid array 20, and any data ball grid in the first part is not linearly adjacent to another data ball grid, that is, the data ball grid 205 (or 206) is not linearly adjacent to any data ball grid (whether in the first part or a second part).
(2) A second part of the data ball grids (201 to 206 in FIG. 2) are located in a non-edge row and non-edge column of the ball grid array 20, and every two data ball grids in the second part are adjacent to each other in the second direction, that is, the data ball grid 201 is adjacent to the data ball grid 202 in the second direction, the data ball grid 203 is adjacent to the data ball grid 204, and the data ball grid 205 is adjacent to the data ball grid 206.

It should be noted that, FIG. 2 shows merely a possible distribution form of the data ball grids, and adaptive adjustment may be performed without departing from the text description. For example, all or some of the data ball grids 201 to 206 are translated rightward by one position.

In this way, in the disclosed embodiment, the data ball grids are allowed to be distributed in an edge row, so that a total quantity of ball grid rows of the ball grid array 20 can be decreased, and a substrate area occupied can be reduced. In addition, the data ball grids are not allowed to be distributed in an edge column, so that the distribution breadth of the data ball grids in the second direction can be reduced as much as possible, a transmission distance of a data signal can be shortened, and quality of the data signal can be better ensured.

In addition, as described above, the ball grid array 20 may be compatible with the X4, X8, and X16 chips, and these chips have different quantities of data signals. Therefore, some or all of the data ball grids may be selectively enabled based on an actual application scenario.

In some embodiments, as shown in FIG. 2, the ball grid array 20 further includes multiple command address ball grids (301 to 307 and 311 to 317), and each of the command address ball grids is configured to transmit a command/address signal ca.
(1) A first part of the command address ball grids (301) are located in an edge row and a non-edge column of the ball grid array 20, and any command address ball grid in the first part is not linearly adjacent to another command address ball grid. As shown in FIG. 2, the command address ball grid 301 (or 307) is not linearly adjacent to any command address ball grid (whether in the first part or a second part).
(2) A second part of the command address ball grids (302 to 306) are located in a non-edge row and non-edge column of the ball grid array 20, a maximum of two of the command address ball grids in the second part are allowed to be consecutively arranged adjacent to each other in the second direction, a maximum of three of the command address ball grids in the second part are allowed to be consecutively arranged adjacent to each other in the first direction. As shown in FIG. 2, the command address ball grid 302, the command address ball grid 303, and the command address ball grid 304 are consecutively arranged in the first direction, and the command address ball grid 303 and the command address ball grid 305 are consecutively arranged in the second direction.

It should be noted that, FIG. 2 shows merely a possible distribution form of the command address ball grids, and adaptive adjustment may be performed without departing from the text description. For example, all or some of the command address ball grids 305 to 307 are translated downward by one position, and the command address ball grid 301 is translated leftward by one position; or the command address ball grid 305 and the command address ball grid 306 are translated leftward by one position, and the command address ball grid 307 is translated rightward by one position.

In this way, in this embodiment of the present disclosure, the command address ball grids are allowed to be distributed in an edge row to reduce an area of the ball grid array 20, so that the quantity of rows occupied by the command address ball grids in the ball grid array 20 can be decreased, space can be further saved, and a time sequence between a clock and an address signal can be better matched. In addition, the command address ball grids are not allowed to be distributed in an edge column, so that the distribution breadth of the command address ball grids in the second direction can be reduced as much as possible, a transmission path of a command address signal can be shortened, and signal transmission quality can be improved.

In some embodiments, the ball grid array 20 has N rows in total, the first part of the data ball grids are located in the first row, the second part of the data ball grids are all located in the second row to the A^{th} row, the second part of the command address ball grids are all located in the B^{th} row to the (N-1)^{th} row, and the first part of the command address ball grids are located in the N^{th} row, A, B, and N are all positive integers, A is less than B, and B is less than N-1.

FIG. 2 is taken as an example. N=13, A=7, and B=9. However, the numbers may be adjusted in an actual application scenario. For example, N is adjusted to 14 or the like.

In a specific embodiment, B>A+1. As shown in FIG. 2, the ball grid array 20 may be divided into a data transmission region, an isolation region, and a command transmission region in the first direction. The data ball grids are all distributed in the data transmission region, the command address ball grids are all distributed in the control transmission region, and the data transmission region and the control transmission region are separated from each other by the isolation region.

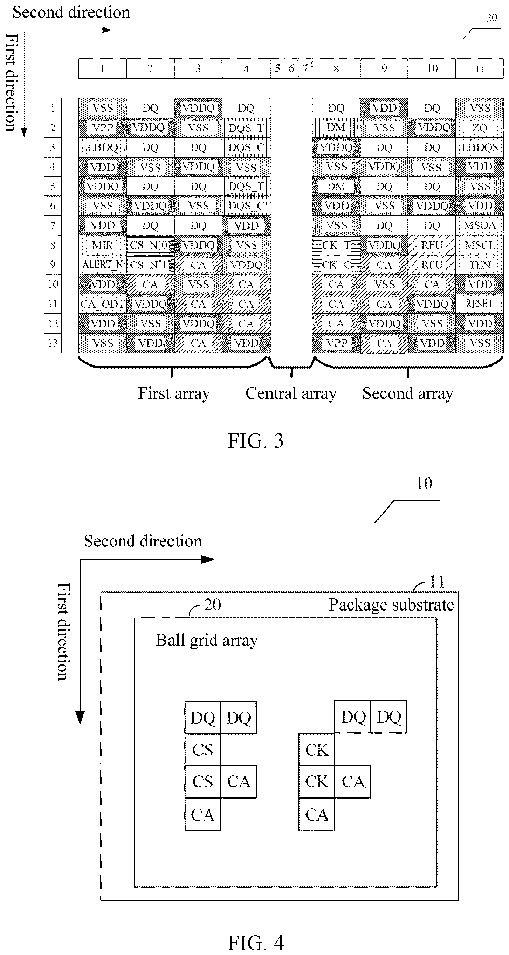

For ease of description, FIG. 3 shows an arrangement illustration of a ball grid array 20 in a specific application scenario of a DDR6 chip. For the purposes of FIG. 3 only, N=13, A=7, and B=9, but this does not constitute a corresponding limitation. The ball grid array 20 has 13 rows×11 columns, and includes 16 data ball grids DQ and 14 command address ball grids CA. It should be understood that, FIG. 3 shows merely a specific implementation of the present disclosure, and the size of the ball grid array 20, the quantities of signals of different types, and a detailed arrangement of the signals may be adaptively adjusted without departing from the following text description.

Referring to FIG. 3, ball grids located in the C^{th} row are all ground ball grids VSS or power ball grids, the ground ball grid VSS is configured to transmit a ground signal vss, and the power ball grid (VDD or VDDQ) is configured to transmit a power signal (vdd or vddq). When A is an odd number, C=(A+1)/2, that is, C=4 in FIG. 4.

In one possibility, the data ball grids DQ located in the first row to the (C-1)^{th} row are configured to transmit an upper data signal (e.g., dqu[7:0] in Table 1), and the data ball grids DQ located in the (C+1)^{th} row to the A^{th} row are configured to transmit a lower data signal (e.g., dql[7:0] in Table 1). Specifically, for the X4 chip, only four data ball grids DQ located in the (C+1)^{th} row to the A^{th} row are enabled; for the X4 chip, only eight data ball grids DQ located in the (C+1)^{th} row to the A^{th} row are enabled; and for the X16 chip, only all the data ball grids DQ are enabled.

In another possibility, the data ball grids DQ located in the first row to the (C-1)^{th} row are configured to transmit a lower data signal (e.g., dql[7:0] in Table 1), and the data ball grids DQ located in the (C+1)^{th} row to the A^{th} row are configured to transmit an upper data signal (e.g., dqu[7:0] in Table 1). Specifically, for the X4 chip, only four data ball grids DQ located in the first row to the (C-1)^{th} row are enabled; for the X4 chip, only eight data ball grids DQ located in the first row to the (C-1)^{th} row are enabled; and for the X16 chip, only all the data ball grids DQ are enabled.

In this way, a lower data ball grid and an upper data ball grid are independent of each other, and the two regions are isolated by the ball grids in the C^{th} row, so that the arrangement is proper, and signal distortion caused by magnetic field superposition can be alleviated.

As shown in FIG. 3, the ball grid array 20 is divided into a first array, a central array, and a second array. The first array, the central array, and the second array are arranged in the second direction. The quantity of ball grids in the first array is the same as the quantity of ball grids in the second array, and all ball grids in the central array are removed. In other words, after the ball grid array 20 is made ready, all ball grids in a central column need to be removed, to facilitate wiring on a PCB or a substrate. There are three central columns in FIG. 3, but this does not constitute a related limitation. There may be more or fewer central columns. In particular, in FIG. 3, the length of each of the central columns (that is, the fifth/sixth/seventh column) is relatively small in the second direction, but this is only for saving page space. Actually, all the columns of the ball grid array 20 basically have the same length in the second direction.

In some embodiments, referring to FIG. 3, the data ball grids DQ located in the first array are symmetrical to the data ball grids located in the second array with respect to the central array. For example, even-numbered data ball grids DQ are distributed in the second, third, and fourth columns, and odd-numbered data ball grids DQ are distributed in the eighth, ninth, and tenth columns; or even-numbered data ball grids DQ are distributed in the eighth, ninth, and tenth columns, and odd-numbered data ball grids DQ are distributed in the second, third, and fourth columns. In this way, the data ball grids DQ in the first array and the second array are mutually mirrored, so that a via hole can be shared when a double-sided placement design is performed on the PCB.

It should be noted that, the ball grid array 20 in FIG. 3 includes 16 data ball grids DQ in total, and can support chips with 4-bit, 8-bit, and 16-bit data bit widths. In short, if the package structure 10 is applied to a chip with a 4-bit data bit width (X4), only four data ball grids are enabled, and the remaining 12 data ball grids are not connected; if the package structure 10 is applied to a chip with an 8-bit data bit width (X8), only eight data ball grids are enabled, and the remaining eight data ball grids are not connected; and if the package structure 10 is applied to a chip with a 16-bit data bit width (X16), all the data ball grids are enabled.

In some embodiments, the command address ball grids CA located in the first array are symmetrical to the command address ball grids CA located in the second array with respect to the central array. For example, even-numbered command address ball grids CA are distributed in the second, third, and fourth columns, and odd-numbered command address ball grids CA are distributed in the eighth, ninth, and tenth columns; or even-numbered command address ball grids CA are distributed in the eighth, ninth, and tenth columns, and odd-numbered command address ball grids CA are distributed in the second, third, and fourth columns. In this way, the command address ball grids CA in the first array and the second array are mutually mirrored, so that a via hole can be shared when a double-sided placement design is performed on the PCB.

In some embodiments, the ball grid array 20 further includes multiple data strobe ball grids (e.g., two DQS_T and two DQS_C in FIG. 3), and each of the data strobe ball grids is configured to transmit a data strobe signal (e.g., dqsl_t, dqsl_c, dqsu_t, or dqsu_c in Table 1). In the second direction, each data strobe ball grid is adjacent to the central array, the data strobe ball grid is allowed to be adjacent to the data ball grid DQ in the first direction, and the data strobe ball grid is allowed to be adjacent to the data ball grid DQ in the second direction, thereby reducing the area of the ball grid array 20.

It should be noted that FIG. 3 shows four data strobe ball grids, but in an actual scenario, there may be more or fewer data strobe ball grids.

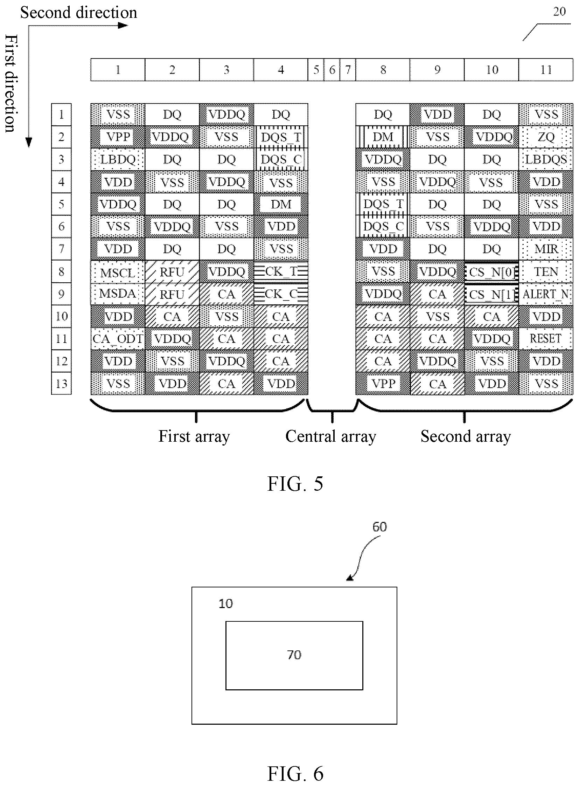

It should be further noted that one data strobe ball grid DQS_T and one data strobe ball grid DQS_C are adjacent to each other in the first direction, and are configured to transmit a pair of differential signals (dqsl_t and dqsl_c are a pair of differential signals, and dqsu_t and dqsu_c are another pair of differential signals), which may be referred to as a group of data strobe ball grids. Data strobe ball grids in different groups are not adjacent to each other in the first direction to reduce signal interference. In addition, in FIG. 3, all the data strobe ball grids are located in the same column, but this is not mandatory. Data strobe ball grids in different groups may be located in different columns (reference is made to FIG. 5), but need to be adjacent to the central column to facilitate wiring on the PCB or the substrate.

In some embodiments, the ball grid array 20 further includes multiple mask control ball grids DM, and each of the mask control ball grids DM is configured to transmit a mask inversion control signal (e.g., dmu or dml in Table 1) or a terminal data strobe signal (e.g., tdqs_t or tdqs_c in Table 1).

It should be noted that FIG. 3 shows two mask control ball grids, but actually, there may be more or fewer mask control ball grids. However, the quantity of mask control ball grids DM is less than or equal to the quantity of data strobe ball grids, and one mask control ball grid DM is symmetrical to one data strobe ball grid with respect to the central array. Similarly, although the mask control ball grids DM in FIG. 3 are located on the same side of the central column, actually, the mask control ball grids DM may alternatively be located on different sides of the central array (reference is made to FIG. 5).

As shown in FIG. 3, each mask control ball grid DM is linearly adjacent "to and to only" one data ball grid DQ. Taking FIG. 3 as an example, one mask control ball grid DM is adjacent to one data ball grid DQ in the first direction, and the other mask control ball grid DM is adjacent to one data ball grid DQ in the second direction, thereby reducing magnetic field superposition as much as possible.

In some embodiments, as shown in FIG. 3, the ball grid array 20 further includes a local data strobe ball grid LBDQS, a local data ball grid LBDQ, and a calibration indication ball grid ZQ. The local data strobe ball grid LBDQS is located in an edge column, and the local data strobe ball grid LBDQS is adjacent to the data ball grid DQ in the second direction. The local data ball grid LBDQ is symmetrical to the local data strobe ball grid LBDQ with respect to the central array, that is, the local data ball grid LBDQ is also located in an edge column, and is adjacent to only one data ball grid DQ in the second direction.

Herein, the local data ball grid LBDQ is configured to transmit a local data signal lbdq, and the local data strobe ball grid LBDQS is configured to transmit a local data strobe signal lbdqs.

As shown in FIG. 3, in the second direction, the local data ball grid LBDQ, one data ball grid DQ, and another one data ball grid DQ are consecutively arranged adjacent to each other; and one data ball grid DQ, another one data ball grid DQ, and the local data strobe ball grid LBDQS are consecutively arranged adjacent to each other.

In some embodiments, the calibration indication ball grid ZQ is adjacent to the local data strobe ball grid LBDQS in the first direction. In FIG. 3, the calibration indication ball grid ZQ is located above the local data strobe ball grid LBDQS, but the calibration indication ball grid ZQ may alternatively be located below the local data strobe ball grid LBDQS, and the calibration indication ball grid ZQ is configured to transmit an impedance calibration signal zq.

In some other embodiments, the calibration indication ball grid ZQ is adjacent to the local data ball grid LBDQ in the first direction, that is, the position of the calibration indication ball grid ZQ in FIG. 3 is exchanged with that of the power ball grid VPP in the first column.

As shown in FIG. 3, in the first row to the A^{th} row (A=7 in FIG. 3), all remaining ball grids that are not mentioned are power ball grids or ground ball grids VSS. Based on different functions and/or voltage values, the power ball grids are identified as VDD, VDDQ, and VPP. In this way, at least one ground ball grid VSS and one power ball grid are distributed around each data ball grid DQ. Herein, "around the data ball grid DQ" includes ball grids that are adjacent to the data ball grid DQ and that are directly above, directly below, directly on the left, directly on the right, on the upper left, on the lower left, on the upper right, and on the lower right of the data ball grid DQ, which not only implements an isolation function, but also facilitates generation of a data signal.

In some embodiments, referring to FIG. 4, the ball grid array 20 further includes multiple chip select ball grids CS adjacent to each other in the first direction, and each of the chip select ball grids CS is configured to transmit a chip select signal (e.g., cs_n[1:0] in Table 1). One part of the chip select ball grids CS are adjacent to one data ball grid DQ in the first direction, and the other part of the chip select ball grids CS are adjacent to one command address ball grid CA in the second direction, and are adjacent to another one command address ball grid CA in the first direction.

It should be noted that, FIG. 4 shows two chip select ball grids CS, but in an actual scenario, there may be more or fewer chip select ball grids CS. In this way, the chip select ball grid CS is allowed to be adjacent to the data ball grid DQ or the command address ball grid CA, and may be adjacent to a maximum of two command address ball grids CA, so that a signal arrangement is more centralized, the size of the ball grid array 20 is further reduced, and a smaller substrate area can be occupied.

In some embodiments, the ball grid array 20 further includes multiple clock ball grids CK adjacent to each other in the first direction, and each of the clock ball grids CK is configured to transmit a clock signal (e.g., ck_c or ck_n in Table 1). One part of the clock ball grids CK are not linearly adjacent to any command address ball grid CA, and are not linearly adjacent to any data ball grid DQ. The other part of the clock ball grids CK are adjacent to one command address ball grid CA in the second direction, and are adjacent to another one command address ball grid CA in the first direction.

It should be noted that, FIG. 4 shows two clock ball grids CK, but in an actual scenario, there may be more or fewer clock ball grids CK. In this way, the clock ball grid is relatively close to the command address ball grid, to better match a latency of a clock and that of an address. Therefore, an overall transmission path is shorter, signal integrity is improved, and a competitive capability of the overall product is improved.

In some embodiments, the multiple chip select ball grids CS are located in the first array and adjacent to an edge column of the ball grid array 20; the multiple clock ball grids CK are located in the second array and adjacent to the central array; and one chip select ball grid CS is located in the same row as one clock ball grid CK.

For example, referring to FIG. 3, the two chip select ball grids may be respectively represented as CS_N[0] and CS _N[1], and are respectively configured to transmit cs_n[0] and cs_n[1], and a maximum of one of cs_n[0] and cs_n[1] is valid. The two clock ball grids may be respectively represented as CK_C and CK_T, and are respectively configured to transmit a pair of differential signals ck_c and ck_t. In addition, the chip select ball grid CS_N[0] and the clock ball grid CK_T are located in the same row, and the chip select ball grid CS_N[1] and the clock ball grid CK_C are located in the same row.

It should be noted that, in FIG. 3, the clock ball grid CK is located in the eighth column, but the clock ball grid CK may alternatively be located in the fourth column (reference is made to FIG. 5), provided that the clock ball grid CK is adjacent to the central array. Therefore, it is easier to implement wiring on the PCB or the substrate.

In some embodiments, referring to FIG. 3, the ball grid array 20 further includes a check error indication ball grid ALERT_N and a mirror mode ball grid MIR, and both the check error indication ball grid ALERT_N and the mirror mode ball grid MIR are located in an edge column of the ball grid array 20. The mirror mode ball grid MIR is adjacent to one chip select ball grid CS_N[0] in the second direction, and the error indication ball grid ALERT_N is adjacent to the other chip select ball grid CS_N[1] in the second direction. The mirror mode ball grid MIR is configured to transmit at least a mirror mode enable signal mir, and the error indication ball grid ALERT _N is configured to transmit a check error indication signal alert_n.

In some other embodiments, the position of the check error indication ball grid ALERT_N may be exchanged with that of the error indication ball grid ALERT _N.

In some embodiments, the ball grid array 20 further includes multiple reserved ball grids RFU, one test mode ball grid TEN, and two protocol ball grids (that is, MSCL and MSDA). The test mode ball grid TEN is configured to transmit a test mode enable signal ten, and the two protocol ball grids are respectively configured to transmit protocol control signals mscl and msda (related to the I3C protocol). The multiple reserved ball grids RFU are symmetrical to the multiple chip select ball grids CS with respect to the central array, a second protocol ball grid is symmetrical to the mirror mode ball grid MIR with respect to the central array, the test mode ball grid TEN is symmetrical to the error indication ball grid ALERT_N with respect to the central array, and a first protocol ball grid MSDA, the second protocol ball grid MSCL, and the test mode ball grid TEN are consecutively arranged in the first direction.

In some other embodiments, positions of the multiple reserved ball grids RFU, the one test mode ball grid TEN, and the two protocol ball grids (that is, MSCL and MSDA) may be flexibly adjusted, mainly depending on arrangement of an internal circuit, provided that it is convenient for input/output of a signal.

In some embodiments, the ball grid array 20 further includes a termination ball grid CA_ODT and a reset ball grid RESET, and the termination ball grid CA_ODT and the reset ball grid RESET are located in an edge column of the ball grid array 20. The termination ball grid CA_ODT is symmetrical to the reset ball grid RESET with respect to the central array. Ball grids linearly adjacent to the termination ball grid CA_ODT are all ground ball grids VSS and/or power ball grids, and the termination ball grid CA_ODT is located in the same row as at least one command address ball grid CA. Ball grids linearly adjacent to the reset ball grid RESET are all ground ball grids VSS and/or power ball grids, and the reset ball grid RESET is located in the same row as at least one command address ball grid CA. The termination ball grid CA_ODT is configured to transmit an on-chip termination command, and the reset ball grid RESET is configured to transmit a reset signal.

Similarly, in some other embodiments, positions of the termination ball grid CA_ODT and the reset ball grid RESET may be flexibly adjusted.

In addition to the above-mentioned signals, other ball grids in the ball grid array 20 are all power ball grids or ground ball grids VSS.

In another embodiment, positions of the following ball grids may be flexibly exchanged: the mask control ball grid DM, the test mode enable ball grid TEN, the reserved ball grid RFU, the mirror mode enable ball grid MIR (configured to control a chip to enter/not to enter a mirror mode), the error indication ball grid ALERT_N (configured to prompt that an error is detected in a cyclic redundancy check operation), the protocol ball grid MSDA/MSCL, the termination ball grid CA_ODT, the reset ball grid RESET, and the calibration ball grid ZQ. Reference is made to FIG. 5. FIG. 5 provides another possible ball grid arrangement.

In some embodiments, referring to FIG. 3, the ball grid array 30 has 13 rows, the first array has four columns, the second array has four columns, and a total of 104 ball grids are provided, which can support signal packaging of the X4, X8, and X16 chips.

In some embodiments, the distance between every two ball grid centers is 800 microns in the first direction, the distance between every two ball grid centers is also 800 microns in the second direction, the overall size of the ball grid array is 10 mm×11 mm, so that the ball grid array is relatively small as a whole, and more package structures may be fabricated based on the same substrate.

It can be learned from the foregoing description that, the package structure provided in the embodiments of the present disclosure may enable X4, X8, and X16 to share a substrate, and the overall size of the ball grid array is small, so that more substrate units can be cut from one substrate, that is, more package structures are formed to reduce costs. In addition, a design cycle may be shortened, and there is no need to design different substrates for chips with different bit widths. In addition, it is found through test that, the ball grid array 20 provided in the present disclosure has a longer solder joint life, a relatively small plastic strain, and a longer fatigue life.

In another embodiment of the present disclosure, FIG. 6 is a schematic structural diagram of composition of a semiconductor structure 60 according to an embodiment of the present disclosure. As shown in FIG. 6, the semiconductor structure 60 includes at least the foregoing package structure 10 and a chip 70, and a data bit width of the chip 70 is 4 bits, 8 bits, or 16 bits. For example, the chip 70 is a DDR6.

Herein, the chip 70 may be disposed on the package structure 10, and the chip 70 may be electrically connected to the ball grid array on the package structure 10. Therefore, various signals related to the chip are output/input through the package structure 10.

In conclusion, the package structure 10 provided in the embodiments of the present disclosure may be compatible with chips with the X4, X8, and X16 specifications, so that chips with different bit widths can share the same substrate. In addition, the size of the substrate is smaller, thereby controlling costs and providing better overall performance.

The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

## Claims

1. A package structure (10), comprising a package substrate (11), a ball grid array (20) being disposed on a surface of the package substrate (11), the ball grid array comprising a plurality of data ball grids (201 to 204), and each of the data ball grids being configured to transmit a data signal; and
in a second direction, a maximum of two of the data ball grids being allowed to be consecutively arranged, and the second direction being a row extension direction of the ball grid array.

2. The package structure according to claim 1, wherein
a first part of the data ball grids are located in an edge row and a non-edge column of the ball grid array, and any one of the data ball grids in the first part is not linearly adjacent to another one of the data ball grids;
a second part of the data ball grids are located in a non-edge row and non-edge column of the ball grid array, and every two of the data ball grids in the second part are adjacent to each other in the second direction; and
the data ball grids are distributed in only one of any two adjacent rows of the ball grid array.

3. The package structure according to claim 1 or 2, wherein the ball grid array further comprises a plurality of command address ball grids, and each of the command address ball grids is configured to transmit a command/address signal;
a first part of the command address ball grids are located in an edge row and a non-edge column of the ball grid array, and any one of the command address ball grids in the first part is not linearly adjacent to another one of the command address ball grids; and
a second part of the command address ball grids are located in a non-edge row and non-edge column of the ball grid array, a maximum of two of the command address ball grids in the second part are allowed to be consecutively arranged in the second direction, a maximum of three of the command address ball grids in the second part are allowed to be consecutively arranged in a first direction, and the first direction is a column extension direction of the ball grid array.

4. The package structure according to claim 3, wherein
the ball grid array has N rows in total, the first part of the data ball grids are located in the first row, the second part of the data ball grids are all located in the second row to the A^{th} row, the second part of the command address ball grids are all located in the B^{th} row to the (N-1)^{th} row, and the first part of the command address ball grids are located in the N^{th} row, A, B, and N are all positive integers, A is less than B, and B is less than N-1.

5. The package structure according to claim 4, wherein
the data ball grids located in the first row to the (C-1)^{th} row are configured to transmit an upper data signal, and the data ball grids located in the (C+1)^{th} row to the A^{th} row are configured to transmit a lower data signal; or the data ball grids located in the first row to the (C-1)^{th} row are configured to transmit a lower data signal, and the data ball grids located in the (C+1)^{th} row to the A^{th} row are configured to transmit an upper data signal; and
each ball grid located in the C^{th} row is a ground ball grid or a power ball grid, the ground ball grid is configured to transmit a ground signal, the power ball grid is configured to transmit a power signal, and C=(A+1)/2.

6. The package structure according to any one of claims 1 to 5, wherein the ball grid array is divided into a first array, a central array, and a second array, the first array, the central array, and the second array are sequentially arranged in the second direction, a quantity of ball grids in the first array is the same as a quantity of ball grids in the second array, and all ball grids in the central array are removed.

7. The package structure according to claim 6, wherein the data ball grids located in the first array are symmetrical to the data ball grids located in the second array with respect to the central array, and the command address ball grids located in the first array are symmetrical to the command address ball grids located in the second array with respect to the central array.

8. The package structure according to claim 6 or 7, wherein the ball grid array further comprises a plurality of data strobe ball grids, and each of the data strobe ball grids is configured to transmit a data strobe signal; and
in the second direction, each of the data strobe ball grids is adjacent to the central array, the data strobe ball grids are allowed to be adjacent to the data ball grids in the first direction, and the data strobe ball grids are allowed to be adjacent to the data ball grids in the second direction.

9. The package structure according to claim 8, wherein the ball grid array further comprises a plurality of mask control ball grids, and each of the mask control ball grids is configured to transmit a mask inversion control signal or a terminal data strobe signal; and
the mask control ball grids are symmetrical to the data strobe ball grids with respect to the central array.

10. The package structure according to any one of claims 6 to 9, wherein the ball grid array further comprises a local data strobe ball grid, a local data ball grid, and a calibration indication ball grid;
the local data strobe ball grid is located in an edge column, and the local data strobe ball grid is adjacent to the data ball grid in the second direction;
the local data strobe ball grid is symmetrical to the local data ball grid with respect to the central array;
the calibration indication ball grid is adjacent to the local data strobe ball grid in the first direction; and
the local data ball grid is configured to transmit a local data signal, the local data strobe ball grid is configured to transmit a local data strobe signal, and the calibration indication ball grid is configured to transmit an impedance calibration signal.

11. The package structure according to any one of claims 3 to 10, wherein the ball grid array further comprises a plurality of chip select ball grids adjacent to each other in the first direction, and each of the chip select ball grids is configured to transmit a chip select signal;
one part of the chip select ball grids are adjacent to one of the data ball grids in the first direction; and
the other part of the chip select ball grids are adjacent to one of the command address ball grids in the second direction, and are adjacent to another one of the command address ball grids in the first direction.

12. The package structure according to any one of claims 1 to 11, wherein the ball grid array further comprises a plurality of clock ball grids adjacent to each other in the first direction, and each of the clock ball grids is configured to transmit a clock signal.

13. The package structure according to claim 12, wherein one part of the clock ball grids are not linearly adjacent to any one of the command address ball grids, and are not linearly adjacent to any one of the data ball grids; and
the other part of the clock ball grids are adjacent to one of the command address ball grids in the second direction, and are adjacent to another one of the command address ball grids in the first direction.

14. The package structure according to claim 12 or 13, wherein
the plurality of chip select ball grids are located in the first array and adjacent to an edge column of the ball grid array;
the plurality of clock ball grids are located in the second array and adjacent to the central array; and
one of the chip select ball grids and one of the clock ball grids are located in a same row.

15. The package structure according to any one of claims 1 to 14, wherein the ball grid array further comprises a check error indication ball grid and a mirror mode ball grid, and both the check error indication ball grid and the mirror mode ball grid are located in an edge column of the ball grid array.

16. The package structure according to claim 15, wherein the mirror mode ball grid is adjacent to one of the chip select ball grids in the second direction;
the error indication ball grid is adjacent to another one of the chip select ball grids in the second direction; and
the mirror mode ball grid is configured to transmit at least a mirror mode enable signal, and the error indication ball grid is configured to transmit a check error indication signal.

17. The package structure according to any one of claims 11 to 16, wherein the ball grid array further comprises a plurality of reserved ball grids, one test mode ball grid, and two protocol ball grids, the test mode ball grid is configured to transmit a test mode enable signal, and each of the protocol ball grids is configured to transmit a protocol control signal;
the plurality of reserved ball grids are symmetrical to the plurality of chip select ball grids with respect to the central array; and
a second one of the protocol ball grids is symmetrical to the mirror mode ball grid with respect to the central array, the test mode ball grid is symmetrical to the error indication ball grid with respect to the central array, and a first one of the protocol ball grids, the second one of the protocol ball grids, and the test mode ball grid are consecutively arranged in the first direction.

18. The package structure according to any one of claims 6 to 17, wherein the ball grid array further comprises a termination ball grid and a reset ball grid, and the termination ball grid and the reset ball grid are located in an edge column of the ball grid array; and
the termination ball grid is symmetrical to the reset ball grid with respect to the central array.

19. The package structure according to claim 18, wherein ball grids linearly adjacent to the termination ball grid are all ground ball grids and/or power ball grids, the termination ball grid is located in a same row as at least one of the command address ball grids, and the reset ball grid is located in a same row as at least one of the command address ball grids; and
the termination ball grid is configured to transmit an on-chip termination command, and the reset ball grid is configured to transmit a reset signal.

20. A semiconductor structure (60), comprising the package structure (10) according to any one of claims 1 to 19 and a chip (70), a data bit width of the chip being 4 bits, 8 bits, or 16 bits.
